# EUROPÄISCHE PATENTSCHRIFT

(11) **EP 1 381 906 B1**
(45) Veröffentlichungstag und Bekanntmachung des Hinweises auf die Patenterteilung: **28.06.2006**
(21) Anmeldenummer: 02730052.4
(22) Anmeldetag: 23.03.2002
(51) Int. Cl.: G02B 27/09, H01S 3/00

(54) **ANORDNUNG FÜR DIE KORREKTUR VON VON EINER LASERLICHTQUELLE AUSGEHENDER LASERSTRAHLUNG SOWIE VERFAHREN ZUR HERSTELLUNG DER ANORDNUNG**
ASSEMBLY FOR CORRECTING LASER ILLUMINATION EMITTED FROM A LASER LIGHT SOURCE AND METHOD FOR PRODUCING SAID ASSEMBLY
ENSEMBLE PERMETTANT DE CORRIGER LE RAYONNEMENT LASER EMIS PAR UNE SOURCE DE RAYONNEMENT LASER ET PROCEDE POUR PRODUIRE CET ENSEMBLE

(30) Priorität: 07.04.2001 DE 10117564; 05.03.2002 DE 10209605
(43) Veröffentlichungstag der Anmeldung: 21.01.2004
(73) Patentinhaber: Hentze-Lissotschenko Patentverwaltungs GmbH & Co. KG, 36419 Gerstengrund (DE)
(72) Erfinder: LISSOTSCHENKO, Vitalij, 58730 Fröndenberg (DE); MIKHAILOV, Alexei, 44227 Dortmund (DE)
(74) Vertreter: Basfeld, Rainer
(86) Internationale Anmeldenummer: PCT/EP2002/003283
(87) Internationale Veröffentlichungsnummer: WO 2002/082164

(56) Entgegenhaltungen:
- WO-A-01/27686
- DE-A- 19 514 626
- DE-A- 19 820 154
- US-A- 5 854 651

## Beschreibung

Die vorliegende Erfindung betrifft eine Anordnung für die Korrektur von von einer Laserlichtquelle ausgehender Laserstrahlung gemäß dem Oberbegriff des Anspruchs 1 oder des Anspruchs 2. Weiterhin betrifft die vorliegende Erfindung ein Verfahren zur Herstellung dieser Anordnung.

Eine Anordnung sowie ein Verfahren der für die Korrektur von von einer Laserlichtquelle ausgehender Laserstrahlung sind aus dem US-Patent US 6,166,759 bekannt. Bei der darin beschriebenen Anordnung wird die bei Laserdiodenbarren in der Regel auftretende sogenannte "Smile"-Verzerrung, die im wesentlichen einer Verbiegung der Reihe von Emissionsquellen entspricht, korrigiert. Als Korrekturmittel wird dabei eine Glasfaser verwendet, die gleichzeitig als Kollimatorlinse wirkt, wobei die Glasfaser im wesentlichen parallel zu der Reihe der Emissionszentren und somit zu der ersten Richtung ausgerichtet ist. Mit Hilfe dieser Glasfaser wird somit auch gleichzeitig die Fast-Axis-Divergenz des von dem Laserdiodenbarren ausgehenden Laserlichts kollimiert. Die Glasfaser wird, um ihrer Korrekturfunktion nachkommen zu können, gezielt mittels eines extrem komplizierten mechanischen Biegeinstrumentes derart verbogen, dass das von den einzelnen zueinander versetzten Emissionszentren ausgehende Licht jeweils etwa mittig auf die dem Laserdiodenbarren zugewandte Querseite der Glasfaser auftrifft. Dadurch werden die durch die Glasfaser hindurchtretenden von den einzelnen Emissionsquellen ausgehenden Lichtstrahlen zwar in sich parallelisiert, weisen aber durchaus noch einen minimalen Strahlversatz gegeneinander auf. Als besonders nachteilig bei dieser aus dem Stand der Technik bekannten Anordnung erweist sich, dass das für die Verbiegung der Glasfaser verwendete Instrument relativ kompliziert aufgebaut ist, weil insbesondere die Glasfaser an einigen Stellen nur um wenige µm beziehungsweise Bruchteile von µm gegenüber anderen Stellen gezielt verbogen werden muss.

Aus dem US-Patent US 5,854,651 sind eine Anordnung sowie ein Verfahren für die Korrektur von von einer Laserlichtquelle ausgehender Laserstrahlung Art bekannt, bei denen als Korrekturmittel unter anderem planparallele Plättchen verwendet werden. Dabei sind diese planparallelen Plättchen in Strahlrichtung hinter einer Kollimationslinse für die Fast-Axis und hinter Fokussierungslinsen für die Slow-Axis sowie weiterhin hinter einer weiteren Fokussierungslinse für die Fast-Axis angeordnet. Die planparallelen Plättchen sind entsprechend der vorher vermessenen "Smile"-Verzerrung zur optischen Achse gekippt. Als nachteilig hierbei erweist sich, dass zum einen für jedes dieser planparallelen Plättchen entsprechend dem vertikalen Versatz des zugeordneten Emissionszentrums des Laserdiodenbarrens ein exakter Verkippungswinkel gegenüber der optischen Achse eingestellt werden muss. Zum anderen ist es als besonders nachteilig anzusehen, dass dieser Winkel aufgrund des sehr exakt zu realisierenden Strahlversatzes ausgesprochen exakt gewählt werden muss. Dies lässt sich unter Umständen nur mit sehr großem Aufwand realisieren.

Aus der DE 198 20 154 A sind eine Anordnung und ein Verfahren der eingangsgenannten Art bekannt. Die darin beschriebene Anordnung weist ein zur Smile-Kompensation dienendes Prismenelement auf. Dieses Prismenelement umfasst eine optisch funktionale Fläche, deren Neigung sich über die Breite des Prismenelementes kontinuierlich ändert. Je nach zu kompensierender Smile-Verzerrung kann die Neigung der optisch funktionalen Fläche entsprechend gewählt werden.

Das der vorliegenden Erfindung zugrundeliegende Problem ist die Schaffung einer Anordnung sowie eines Verfahrens der eingangs genannten Art, die einfacher realisierbar sind.

Dies wird erfindungsgemäß hinsichtlich der Anordnung durch die kennzeichnenden Merkmale der Ansprüche 1 und 3 sowie hinsichtlich des Verfahrens durch die kennzeichnenden Merkmale des Anspruchs 14 erzielt.

Gemäß Anspruch 1 ist vorgesehen, dass die Korrekturmittel eine Mehrzahl von einzelnen Prismenelementen umfassen, die derart zusammengefügt sind, dass sie ein Prismenarray bilden. Ein derartiges Prismenarray ist einfacher herstellbar als die aus dem Stand der Technik bekannte verbogene Glasfaser.

Die Prismenelemente sind derart in der von der Laserlichtquelle ausgehenden Laserstrahlung angeordnet, dass die von mindestens zwei zueinander versetzten Emissionsquellen ausgehenden Lichtstrahlen auf unterschiedliche Prismenelemente auftreffen und an einer derer Prismenflächen derart unter einem unterschiedlichen Winkel abgelenkt werden, dass die durch die Versetzung dieser Emissionsquellen bewirkte Verzerrung korrigiert wird. Letztlich muss zur Herstellung eines derartigen Prismenarrays lediglich eine sich um genügend kleine Winkel unterscheidende Anzahl von Prismenelementen vorhanden sein, so dass nach entsprechender Analyse der "Smile"-Verzerrung die für die Korrektur passenden Elemente aneinander gefügt, insbesondere aneinander geklebt werden. Ein derartiges Prismenarray kann in Strahlrichtung hinter einer Zylinderlinse angeordnet werden, die als Kollimatorlinse der Fast-Axis-Divergenz dient.

Gemäß Anspruch 2 ist vorgesehen, dass die Korrekturmittel als Plattenarray ausgeführt sind und das Plattenarray eine Anzahl von Plattenelementen umfasst, die aus planparallelen, für die verwendete Laserstrahlung transparenten Platten bestehen, wobei mindestens zwei der Plattenelemente eine unterschiedliche Dicke aufweisen und die Korrekturmittel derart in der von der Laserlichtquelle ausgehenden Laserstrahlung angeordnet sind, dass die von mindestens zwei zueinander versetzten Emissionsquellen ausgehenden Lichtstrahlen von zwei verschiedenen Plattenelementen einen unterschiedlich starken Strahlenversatz erfahren, so dass die durch die Versetzung dieser Emissionsquellen bewirkte Verzerrung ausgeglichen wird. Auch ein derartiges Plattenarray ist einfacher herstellbar als die aus dem Stand der Technik bekannte Glasfaser.

Vorteilhafterweise kann das Korrekturmittel unter einem vorgebbaren Winkel zur mittleren Ausbreitungsrichtung der durch sie hindurchtretenden Laserstrahlung angeordnet sein. Insbesondere kann die Normale auf einer Eintrittsfläche der Korrekturmittel unter dem vorgebbaren Winkel zu der mittleren Ausbreitungsrichtung der durch die Korrekturmittel hindurchtretenden Laserstrahlung angeordnet sein. Hierbei kann der Winkel nach Einbringung des als Korrekturmittel dienenden Plattenarrays in den Strahlengang gezielt verändert werden bis eine optimale Korrektur der "Smile"-Verzerrung erreicht ist. Dies bietet deutliche Vorteile gegenüber der US 5,854,651, weil bei der darin beschriebenen Anordnung der Winkel als einzig veränderbarer Parameter sehr exakt eingestellt werden muss.

Es besteht erfindungsgemäß die Möglichkeit, dass die Korrekturmittel als einstückiger monolithischer Block ausgebildet sind. Durch diese Ausbildung gestaltet sich die Fertigung der Korrekturmittel wesentlich einfacher, weil keine voneinander getrennt hergestellten Plättchen zueinander positioniert und miteinander verklebt werden müssen. Ein derartiges Plattenarray kann beispielsweise dadurch hergestellt werden, dass die von der Laserlichtquelle ausgehende Laserstrahlung nach Durchtritt durch eine Zylinderlinse, deren Zylinderachsen im wesentlichen parallel zu der ersten Richtung ausgerichtet sind, in der sich auch die Reihe der Emissionsquellen erstreckt, hinsichtlich ihrer räumlichen Verteilung analysiert wird und daran anschließend entsprechend der Analyse die Dicken der einzelnen Plattenelemente gewählt werden.

Auch dieses Plattenarray kann hinter einer Zylinderlinse angeordnet sein, die das von der beispielsweise als Laserdiodenbarren ausgebildeten Laserlichtquelle ausgehende Licht hinsichtlich der Fast-Axis-Divergenz fokussiert.

Um die nach dem Durchgang durch die Zylinderlinse und durch das Plattenarray fokussierte Laserstrahlung wieder in eine hinsichtlich der Fast-Axis parallele Strahlung zu überführen, kann auf der von der Zylinderlinse abgewandten Seite des als Plattenarrays ausgebildeten Korrekturmittels eine Konkavlinse angeordnet sein, die die hinsichtlich der zu der ersten Richtung senkrechten Richtung fokussierte Laserstrahlung derart bricht, dass diese als bezüglich zu der ersten Richtung senkrechten Richtung im wesentlichen parallele Laserstrahlung aus der Konkavlinse austritt. Diese dann parallele Laserstrahlung kann einfacher weiter verarbeitet werden, insbesondere auf eine Glasfaser abgebildet werden.

Als besonderer Vorteil der vorgenannten Anordnungen ist anzusehen, dass die Laserlichtquelle vor der Analyse der Laserstrahlung auf eine Kühlvorrichtung aufgebracht werden kann. In der Regel wird bei Laserdiodenbarren durch Aufschrauben auf eine beispielsweise als Kupferplatte ausgeführte Kühlvorrichtung die "Smile"-Verzerrung erst erzeugt beziehungsweise vergrößert. Die erfindungsgemäße Anordnung beziehungsweise das Verfahren zur Herstellung der erfindungsgemäßen Anordnung ermöglichen eine Analyse und Korrektur der "Smile"-Verzerrung nach fertiger Montage des Laserdiodenbarrens auf einer Kühlvorrichtung. Durch die erfindungsgemäße Anordnung werden somit auch die Verzerrungen korrigiert, die erst durch die Montage des Laserdiodenbarrens entstehen.

Bei den vorgenannten erfindungsgemäßen Anordnungen können jedem der Prismenelemente beziehungsweise jedem der Plattenelemente eine oder mehrere der Emissionsquellen zugeordnet sein. Die Anzahl der einem jedem der vorgenannten Elemente zugeordneten Emissionsquellen hängt natürlich zum einen vom Grad der Versetzung der einzelnen Emissionsquellen zueinander ab und zum anderen von der Genauigkeit, mit der die Korrektur durchgeführt werden soll. In der Regel wäre sicherlich die exakteste Korrektur genau dann gegeben, wenn für jede einzelne Emissionsquelle ein einzelnes der Prismenelemente oder Plattenelemente vorgesehen ist, das entsprechend der Versetzung dieser einzelnen Emissionsquelle gestaltet beziehungsweise angeordnet ist.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1 a: eine schematische Ansicht auf eine Anzahl von Emissionsquellen eines Laserdiodenbarrens in einer idealen Anordnung;
- Fig. 1b: eine schematische Ansicht auf Emissionsquellen eines Laserdiodenbarrens in einer überzeichnet dargestellten fehlerhaften Anordnung;
- Fig. 2a: eine Seitenansicht einer aus dem Stand der Technik bekannten Kollimationseinrichtung mit einer Laserlichtquelle gemäß Fig. 1 b;
- Fig. 2b: eine Ansicht gemäß dem Pfeil IIb in Fig. 2a;
- Fig. 3: eine Seitenansicht auf eine Fokussierungsanordnung mit einer Laserlichtquelle gemäß Fig. 1 b;
- Fig. 4a: eine perspektivische Ansicht einer erfindungsgemäßen Anordnung mit einer ersten Ausführungsform eines erfindungsgemäßen Korrekturmittels;
- Fig. 4b: eine Seitenansicht der Anordnung gemäß Fig. 5a;
- Fig. 5a: eine Seitenansicht eines zweiten erfindungsgemäßen Korrekturmittels;
- Fig. 5b: eine Ansicht gemäß dem Pfeil Vb in Fig. 5a;
- Fig. 6a: eine erfindungsgemäße Anordnung mit dem zweiten erfindungsgemäßen Korrekturmittel;
- Fig. 6b: eine Ansicht gemäß dem Pfeil Vlb in Fig. 6a;
- Fig. 7: eine Seitenansicht einer weiteren Ausführungsform einer erfindungsgemäßen Anordnung mit dem zweiten erfindungsgemäßen Korrekturmittel.

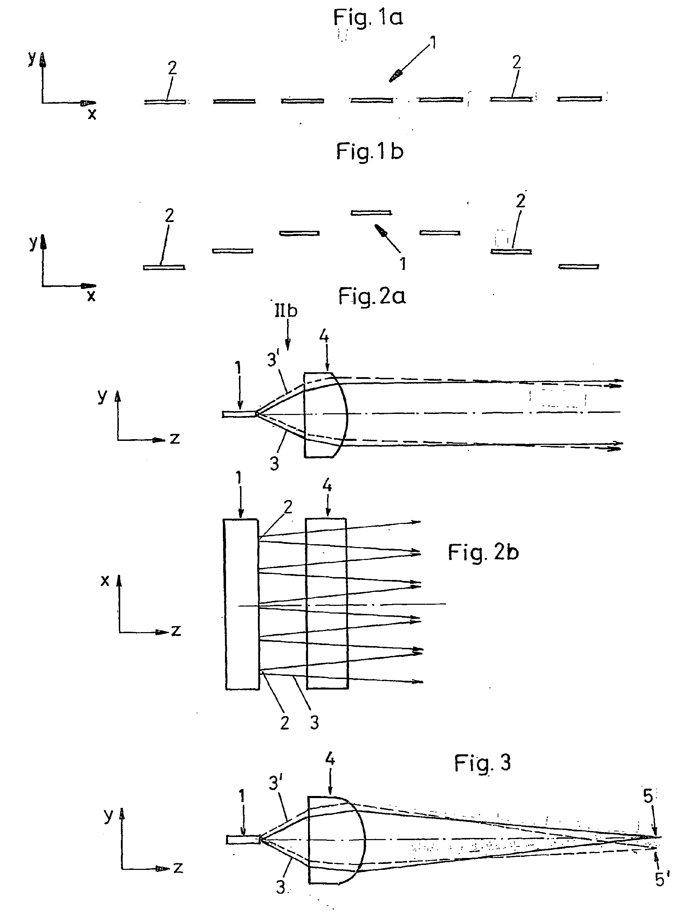

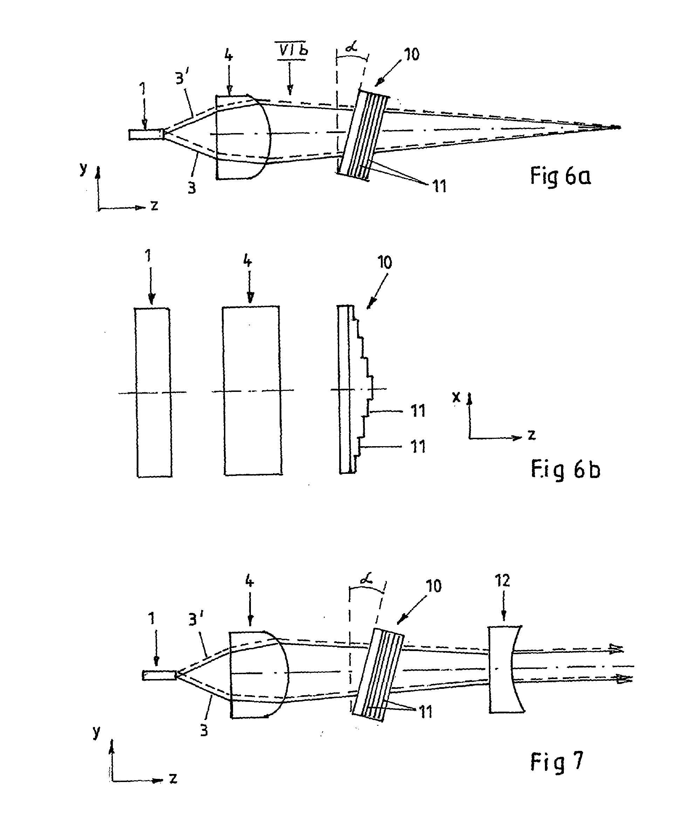

In den Fig. 1 bis Fig. 4 sowie in den Fig. 6 und Fig. 7 sind zur Verdeutlichung der Orientierung Koordinatensysteme eingezeichnet.

Aus Fig. 1a ist eine schematische Ansicht auf eine Laserlichtquelle 1 mit in einer Reihe angeordneten Emissionsquellen 2 abgebildet. Derartige Laserlichtquellen 1 sind in der Regel als Laserdiodenbarren ausgeführt. Dabei können die Dimensionen beispielsweise derart sein, dass die gesamte Breite des Laserdiodenbarrens in Richtung der abgebildeten Reihe etwa 10 mm beträgt, wohingegen die Breite in Reihenrichtung der einzelnen Emissionsquellen 2 etwa 200 µm beträgt. Die Proportionen sind hier somit nicht naturgetreu, sondem lediglich schematisch wiedergegeben, um die mit der im nachfolgenden noch näher beschriebenen "Smile"-Verzerrung zusammenhängenden Probleme zu verdeutlichen. Die Ausbreitung der Emissionsquellen 2 in einer Richtung senkrecht zur Reihenrichtung beträgt beispielsweise 1 µm.

In Fig. 1b sind Emissionsquellen 2 abgebildet, die nicht ideal angeordnet sind und somit in etwa das von einem Laserdiodenbarren ausgesandte Licht wiedergeben. Man sieht deutlich, dass die einzelnen Emissionsquellen 2 von einer Reihenanordnung abweichen. Diese Abweichung ist in Fig. 1 b zur Verdeutlichung sehr drastisch dargestellt. Diese Abweichungen können sich in einem Größenordnungsbereich zwischen 0,1 µm bis 5 µm bewegen. Es soll noch einmal deutlich zum Ausdruck gebracht werden, dass die hier gegenüber der Höhe der Emissionsquellen 2 ausgesprochen großen Abweichungen lediglich zur Verdeutlichung in dieser Größe gewählt wurden.

Eine derartige Verzerrung des von dem Laserdiodenbarren ausgehenden Laserlichtes wird im allgemeinen als "Smile"-Verzerrung bezeichnet und kann zum Beispiel dadurch hervorgerufen beziehungsweise verstärkt werden, dass der Laserdiodenbarren mit entsprechenden Haltemitteln auf eine Unterlage aufgeschraubt wird, die beispielsweise aus einem Kupferblock zur Wärmeableitung besteht.

Aus Fig. 2 ist ersichtlich, dass die Kollimierung von Lichtstrahlen 3, 3', die von einer Laserlichtquelle 1 gemäß Fig. 1 b ausgehen, Probleme mit sich bringt. In Fig. 2 ist mit dem Bezugszeichen 4 eine konvexe Zylinderlinse bezeichnet, die in dieser Anordnung als Kollimationslinse der Fast-Axis-Divergenz des von dem Laserdiodenbarren ausgehenden Laserlichtes dient. Aufgrund der Tatsache, dass einzelne Emissionsquellen 2 zueinander in Y-Richtung versetzt sind, ergeben sich nur für Lichtstrahlen 3, die von im wesentlichen auf der optischen Achse der Anordnung gemäß Fig. 2 liegenden Emissionsquellen 2 ausgehen, nach dem Durchtritt durch die Zylinderlinse 4 zu der optischen Achse und damit zur Z-Richtung parallele Strahlen. Lichtstrahlen 3', die beispielsweise zu der optischen Achse nach oben versetzt sind, verlassen die Zylinderlinse 4 unter einem Winkel zur optischen Achse beziehungsweise zur Z-Richtung. Die Abweichung der Lichtstrahlen 3, 3' voneinander ist zur Verdeutlichung übertrieben groß dargestellt. Die Abbildung von Laserstrahlung aus derartigen Lichtstrahlen 3, 3' beispielsweise auf eine Lichtleitfaser erweist sich als ausgesprochen schwierig beziehungsweise ohne entsprechende Korrekturmittel als sehr ineffektiv.

In Fig. 3 ist die Zylinderlinse 4, die in Fig. 2 zu Kollimierung diente, als Fokussierlinse ausgebildet, so dass die durch die Zylinderlinse 4 hindurchtretenden Strahlen in eine Brennebene fokussiert werden. Alternativ dazu kann der Übergang von Fig. 2a zu Fig. 3 auch dadurch erreicht werden, dass der Abstand zwischen der Zylinderlinse 4 und der Laserlichtquelle 1 verändert wird. Aufgrund der versetzten Anordnung einzelner Emissionsquellen 2 in Y-Richtung ergibt sich auch eine versetzte Anordnung der Fokuspunkte 5, 5' der von den unterschiedlichen Emissionsquellen 2 ausgehenden Lichtstrahlen 3, 3'.

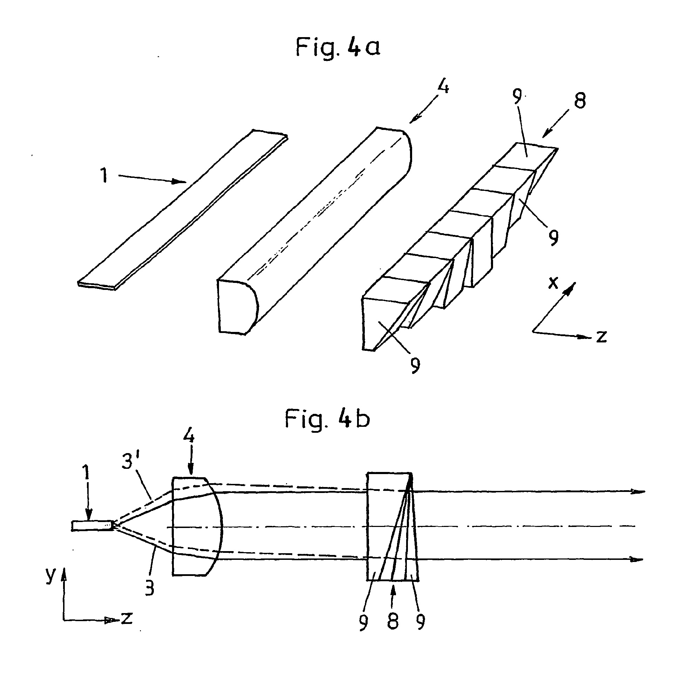

Aus Fig. 4 ist eine erste erfindungsgemäße Anordnung ersichtlich, bei der ein als Prismenarray ausgeführtes Korrekturmittel 8 Verwendung findet. Bei dieser Anordnung kann zuerst das aus der Zylinderlinse 4 austretende Licht hinsichtlich seiner räumlichen Verteilung analysiert werden. Daran anschließend werden Prismenelemente 9 erstellt, die sich durch unterschiedliche Prismenwinkel unterscheiden. Daran anschließend werden diese Prismenelemente 9 zu dem Prismenarray zusammengefügt. Hierbei kann jeweils eines der Prismenelemente 9 einer oder mehreren der Emissionsquellen 2 zugeordnet werden. Das als Prismenarray ausgeführte Korrekturmittel 8 wird in Z-Richtung hinter der Zylinderlinse 4 angeordnet, wobei die Zylinderlinse 4 als Kollimationslinse angeordnet ist, so dass die aus der Zylinderlinse 4 austretenden Strahlen 3, 3'im wesentlichen in sich parallel sind. Diese in sich parallelen Strahlen 3, 3' werden in den einzelnen Prismenelementen 9 je nach Prismenwinkel mehr oder weniger stark abgelenkt. Die Positionierung des Prismenarrays in den Strahlengängen der aus der Zylinderlinse 4 austretenden Strahlen 3, 3' sollte derart gewählt werden, dass die zur Ablenkung verwendeten Prismenflächen etwa im Bereich der Schnittpunkte der Strahlen 3, 3' hinter der Zylinderlinse 4 angeordnet sind (siehe dazu auch Fig. 2a), so dass die abgelenkten Strahlen 3, 3' etwa an der gleichen Position das Prismenarray verlassen. Der vorgenannte Bereich ist unter anderem abhängig von der Brennweite der Zylinderlinse 4 und ist in Fig. 2a und Fig. 4b nur prinzipiell dargestellt. Aus Fig. 4b ist entnehmbar, dass nach dem Durchgang durch das als Prismenarray ausgeführte Korrekturmittel 8 alle von den unterschiedlichen Emissionsquellen 2 ausgehenden Strahlen 3, 3' parallel zueinander verlaufen und in Y-Richtung im wesentlichen gleich angeordnet sind.

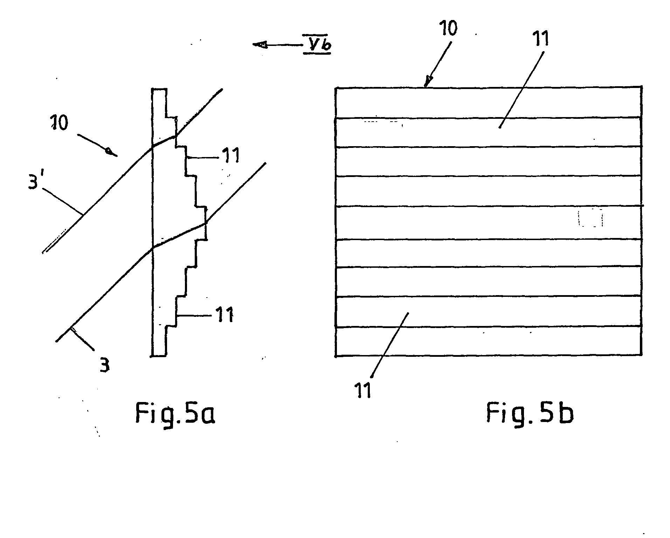

In Fig. 6a ist eine zweite Ausführungsform einer erfindungsgemäßen Anordnung abgebildet, die eine zweite Ausführungsform eines Korrekturmittels 10 (siehe auch Fig. 5a und Fig. 5b) umfasst. Bei diesem Korrekturmittel 10 sind jeweils einer oder mehreren der Emissionsquellen 2 Plattenelemente 11 zugeordnet, die zu einem das Korrekturmittel 10 bildenden Plattenarray zusammengefasst sind. Die Plattenelemente 11 können beispielsweise aus planparallelen Plättchen eines transparenten Materials bestehen. In dem abgebildeten Ausführungsbeispiel sind die Plattenelemente 11 als einzelne Abschnitte eines einstückigen Plattenarrays ausgebildet. Die einzelnen Plattenelemente 11 weisen je nach zu korrigierendem Lichtstrahl 3, 3' eine geeignete Dicke auf. Aus Fig. 5a ist ersichtlich, dass bei schrägem Einfall in ein derartiges Plattenarray 10 Lichtstrahlen 3, 3', die durch unterschiedlich dicke Plattenelemente 11 hindurchtreten, einen unterschiedlich starken Strahlversatz erfahren.

Es kann beispielsweise vorgesehen sein, dass vor Fertigung des als Korrekturmittel 10 dienenden Plattenarrays das aus der Zylinderlinse 4 austretende Licht hinsichtlich seiner räumlichen Verteilung analysiert wird. Daran anschließend wird ein Plattenarray mit unterschiedlich dicken Plattenelementen 11 gefertigt, wobei die Dicke der einzelnen Plattenelemente 11 abhängig von dem entsprechenden Versatz in X-Richtung der Emissionsquellen 2 ist, deren Lichtstrahlen 3, 3' durch das entsprechende Plattenelement 11 hindurchtreten. Daran anschließend wird das als Korrekturmittel 10 dienende Plattenarray gemäß Fig. 6a und Fig. 6b in dem Strahlengang hinter der Zylinderlinse 4 angeordnet und unter einem Winkel α zur Y-Richtung gekippt.

Als besonders interessanter Vorteil der Erfindung erweist sich hierbei, dass der Winkel α nach Einbringung des als Korrekturmittel 10 dienenden Plattenarrays in den Strahlengang gezielt verändert werden kann bis eine optimale Korrektur der "Smile"-Verzerrung erreicht ist.

Aus Fig. 6a ist ersichtlich, dass das Korrekturmittel 10 in einer Anordnung eingebracht ist, bei der die Zylinderlinse 4 als Fokussierungslinse dient, so dass die Strahlen 3, 3' in eine Brennebene fokussiert werden. Da planparallele Platten einen Strahlversatz verursachen, können somit auch durch das als Plattenarray ausgeführte Korrekturmittel 10 Strahlversatze der von der Zylinderlinse 4 fokussierten Lichtstrahlen 3, 3' erzielt werden, so dass nach dem Durchtritt durch das Korrekturmittel 10 die Strahlen 3, 3' von unterschiedlichen Emissionszentren 2 hinsichtlich der Y-Richtung in der Brennebene zusammenfallen.

In Fig. 7 ist verdeutlicht, dass das durch das als Plattenarray ausgeführte Korrekturmittel 10 hindurchgefallene Licht vermittels einer beispielsweise als Zylinderlinse ausgebildeten Konkavlinse 12 in hinsichtlich der Fast-Axis beziehungsweise der Y-Richtung zur Z-Richtung paralleles Licht umgewandelt werden kann, so dass durch die aus Zylinderlinsen 4, Korrekturmittel 10 und Konkavlinsen 12 gebildete Anordnung eine Fast-Axis-Kollimlerung mit gleichzeitiger "Smile"-Korrektur realisiert wird.

Die Zylinderlinse 4 kann natürlich in sämtlichen abgebildeten Ausführungsformen durch eine zylinderlinsenähnliche oder funktional gleichwirkende Linse ersetzt werden.

## Patentansprüche

1. Anordnung für die Korrektur von von einer Laserlichtquelle (1) ausgehender Laserstrahlung, umfassend eine Laserlichtquelle (1), die linienförmige Emissionsquellen (2) aufweist, die in mindestens einer Reihe in einer ersten Richtung (X) angeordnet sind, wobei weiterhin die in einer Reihe angeordneten Emissionsquellen (2) in einer zu der ersten Richtung (X) senkrechten Richtung (Y) zumindest teilweise zu der Reihe versetzt angeordnet sind, und wobei weiterhin die Anordnung Korrekturmittel (8, 10) mit mindestens einem Prismenelement (9) umfasst, die die von der Laserlichtquelle (1) ausgehende Laserstrahlung derart korrigieren können, dass die durch die Versetzung der Emissionsquellen (2) zu der Reihe bewirkte räumliche Verzerrung der Laserstrahlung ausgeglichen wird, **dadurch gekennzeichnet, dass** die Korrekturmittel (8) eine Mehrzahl von einzelnen Prismenelementen umfassen, die derart zusammengefügt sind, dass sie ein Prismenarray bilden, wobei die
Prismenelemente (9) derart in der von der Laserlichtquelle (1) ausgehenden Laserstrahlung angeordnet sind, dass die von mindestens zwei zueinander versetzten Emissionsquellen (2) ausgehenden Lichtstrahlen (3, 3') auf unterschiedliche Prismenelemente (9) auftreffen und an einer derer Prismenflächen derart unter einem unterschiedlichen Winkel abgelenkt werden, dass die durch die Versetzung dieser Emissionsquellen bewirkte Verzerrung korrigiert wird.

2. Anordnung für die Korrektur von von einer Laserlichtquelle (1) ausgehender Laserstrahlung, umfassend eine Laserlichtquelle (1), die linienförmige Emissionsquellen (2) aufweist, die in mindestens einer Reihe in einer ersten Richtung (X) angeordnet sind, wobei weiterhin die in einer Reihe angeordneten Emissionsquellen (2) in einer zu der ersten Richtung (X) senkrechten Richtung (Y) zumindest teilweise zu der Reihe versetzt angeordnet sind, und wobei weiterhin die Anordnung Korrekturmittel (8, 10) umfasst, die die von der Laserlichtquelle (1) ausgehende Laserstrahlung derart korrigieren können, dass die durch die Versetzung der Emissionsquellen (2) zu der Reihe bewirkte räumliche Verzerrung der Laserstrahlung ausgeglichen wird, **dadurch gekennzeichnet, dass** die Korrekturmittel (10) als Plattenarray ausgeführt sind und das Plattenarray eine Anzahl von Plattenelementen (11) umfasst, die aus planparallelen, für die verwendete Laserstrahlung transparenten Platten bestehen, wobei mindestens zwei der Plattenelemente (11) eine unterschiedliche Dicke aufweisen und wobei die Korrekturmittel (10) derart in der von der Laserlichtquelle (1) ausgehenden Laserstrahlung angeordnet sind, dass die von mindestens zwei zueinander versetzten Emissionsquellen (2) ausgehenden Lichtstrahlen (3, 3') von zwei verschiedenen Plattenelementen (11) einen unterschiedlich starken Strahlenversatz erfahren, so dass die durch die Versetzung dieser Emissionsquellen (2) bewirkte Verzerrung ausgeglichen wird.

3. Anordnung nach Anspruch 2, **dadurch gekennzeichnet, dass** das Korrekturmittel (10) unter einem vorgebbaren Winkel (α) zur mittleren Ausbreitungsrichtung der durch sie hindurchtretenden Laserstrahlung angeordnet ist.

4. Anordnung nach Anspruch 3, **dadurch gekennzeichnet, dass** die Normale auf einer Eintrittsfläche der Korrekturmittel (10) unter einem Winkel (α) zu der mittleren Ausbreitungsrichtung (Z) der durch die Korrekturmittel (10) hindurchtretenden Laserstrahlung angeordnet ist.

5. Anordnung nach einem der Ansprüche 2 bis 4, **dadurch gekennzeichnet, dass** die Korrekturmittel (10) als einstückiger monolithischer Block ausgebildet sind.

6. Anordnung nach einem der Ansprüche 1 bis 5, **dadurch gekennzeichnet, dass** zwischen den Korrekturmitteln (8, 10) und der Laserlichtquelle eine Zylinderlinse (4) angeordnet ist, deren Zylinderachse sich in der ersten Richtung (X) erstreckt.

7. Anordnung nach Anspruch 6, **dadurch gekennzeichnet, dass** die Zylinderlinse (4) eine Kollimierung der von der Laserlichtquelle (1) ausgehenden Laserstrahlung in einer zu der ersten Richtung (X) senkrechten Richtung (Y) bewirkt.

8. Anordnung nach Anspruch 6, **dadurch gekennzeichnet, dass** die Zylinderlinse (4) eine Fokussierung der von der Laserlichtquelle (1) ausgehenden Laserstrahlung in einer zu der ersten Richtung (X) senkrechten Richtung (Y) bewirkt.

9. Anordnung nach Anspruch 8, **dadurch gekennzeichnet, dass** auf der von der Zylinderlinse (4) abgewandten Seite der als Plattenarray ausgebildeten Korrekturmittel (10) eine Konkavlinse (12) angeordnet ist, die die hinsichtlich der zu der ersten Richtung (X) senkrechten Richtung (Y) fokussierte Laserstrahlung derart bricht, dass diese als bezüglich zu der ersten Richtung (X) senkrechten Richtung (Y) im wesentlichen parallele Laserstrahlung aus der Konkavlinse (12) austritt.

10. Anordnung nach einem der Ansprüche 1 bis 4 oder 6 bis 9, **dadurch gekennzeichnet, dass** die Prismenelemente (9) oder die Plattenelemente (11) aneinander geklebt sind.

11. Anordnung nach einem der Ansprüche 1 bis 10, **dadurch gekennzeichnet, dass** jedem der Prismenelemente (9) beziehungsweise jedem der Plattenelemente (11) eine oder mehrere der Emissionsquellen (2) zugeordnet sind.

12. Anordnung nach einem der Ansprüche 1 bis 11, **dadurch gekennzeichnet, dass** die Laserlichtquelle (1) als Laserdiodenbarren ausgeführt ist.

13. Verfahren zur Herstellung einer Anordnung nach einem der Ansprüche 1 bis 12, **gekennzeichnet durch** die folgenden Verfahrensschritte:
- die von der Laserlichtquelle (1) ausgehende Laserstrahlung wird nach Durchtritt **durch** eine Zylinderlinse (4), deren Zylinderachsen parallel zu der ersten Richtung (X) ausgerichtet sind, in der sich auch die Reihe der Emissionsquellen (2) erstreckt, hinsichtlich der **durch** die Versetzung der Emissionsquellen (2) zu der Reihe bewirkten räumlichen Verzerrung der Laserstrahlung analysiert;
- entsprechend der im Rahmen der Analyse ermittelten **durch** die Versetzung der Emissionsquellen (2) zu der Reihe bewirkten räumlichen Verzerrung der Laserstrahlung werden die Prismenwinkel der einzelnen Prismenelemente (9) zueinander oder die Dicken der einzelnen Plattenelemente (11) gewählt.

14. Verfahren nach Anspruch 13, **dadurch gekennzeichnet, dass** vor der Analyse der Laserstrahlung die Laserlichtquelle (1) auf eine Kühlvorrichtung aufgebracht wird.

## Claims

1. Arrangement for correcting laser radiation emanating from a laser light source (1), comprising a laser light source (1) having linear emission sources (2) arranged in at least one row in a first direction (X), the emission sources (2) arranged in a row furthermore being offset at least partially from the row in a direction (Y) perpendicular to the first direction (X), and the arrangement furthermore comprising correction means (8, 10), having at least one prism element (9), which can correct the laser radiation emanating from the laser light source (1) in such a way that the spatial distortion of the laser radiation effected by the offset of the emission sources (2) from the row is compensated, **characterized in that** the correction means (8) comprise a plurality of individual prism elements which are joined in such a way that they form a prism array, the prism elements (9) being arranged in the laser radiation emanating from the laser light source (1) in such a way that the light beams (3, 3') emanating from at least two mutually offset emission sources (2) impinge on different prism elements (9), and are deflected at a different angle at one of the prism surfaces thereof in such a way that the distortion effected by the offsetting of these emission sources is corrected.

2. Arrangement for correcting laser radiation emanating from a laser light source (1), comprising a laser light source (1) having linear emission sources (2) arranged in at least one row in a first direction (X), the emission sources (2) arranged in a row furthermore being offset at least partially from the row in a direction (Y) perpendicular to the first direction (X), and the arrangement furthermore comprising correction means (8, 10), which can correct the laser radiation emanating from the laser light source (1) in such a way that the spatial distortion of the laser radiation effected by the offset of the emission sources (2) from the row is compensated, **characterized in that** the correction means (10) are designed as a plate array, and the plate array comprises a number of plate elements (11) which consist of plane-parallel plates transparent to the laser radiation used, at least two of the plate elements (11) having a different thickness, and the correction means (10) being arranged in the laser radiation emanating from the laser light source (1) in such a way that the light beams (3, 3'), emanating from at least two mutually offset emission sources (2), of two different plate elements (11) experience a beam offset of different magnitude such that the distortion effected by the offsetting of these emission sources (2) is compensated.

3. Arrangement according to Claim 2, **characterized in that** the correction means (10) is arranged at a predeterminable angle (α) to the average direction of propagation of the laser radiation penetrating therethrough.

4. Arrangement according to Claim 3, **characterized in that** the normal to an entrance surface of the correction means (10) is arranged at an angle (α) to the average direction of propagation (Z) of the laser radiation penetrating through the correction means (10).

5. Arrangement according to one of Claims 2 to 4, **characterized in that** the correction means (10) are designed as a unipartite monolithic block.

6. Arrangement according to one of Claims 1 to 5, **characterized in that** a cylindrical lens (4) whose cylinder axis extends in the first direction (X) is arranged between the correction means (8, 10) and the laser light source.

7. Arrangement according to Claim 6, **characterized in that** the cylindrical lens (4) effects a collimation of the laser radiation, emanating from the laser light source (1), in a direction (Y) perpendicular to the first direction (X).

8. Arrangement according to Claim 6, **characterized in that** the cylindrical lens (4) effects a focusing of the laser radiation, emanating from the laser light source (1), in a direction (Y) perpendicular to the first direction (X).

9. Arrangement according to Claim 8, **characterized in that** arranged on the side, averted from the cylindrical lens (4), of the correction means (10) designed as a plate array is a concave lens (12) which refracts the laser radiation focused with regard to the direction (Y) perpendicular to the first direction (X) in such a way that this laser radiation emanates from the concave lens (12) as laser radiation substantially parallel as regards the direction (Y) perpendicular to the first direction (X).

10. Arrangement according to one of Claims 1 to 4 or 6 to 9, **characterized in that** the prism elements (9) or the plate elements (11) are bonded onto one another.

11. Arrangement according to one of Claims 1 to 10, **characterized in that** each of the prism elements (9) or each of the plate elements (11) is assigned one or more of the emission sources (2).

12. Arrangement according to one of Claims 1 to 11, **characterized in that** the laser light source (1) is designed as a laser diode bar.

13. Method for producing an arrangement according to one of Claims 1 to 12, **characterized by** the following method steps:
- after passing through a cylindrical lens (4) whose cylinder axes are aligned parallel to the first direction (X) in which the row of the emission sources (2) also extends, the laser radiation emanating from the laser light source (1) is analysed with regard to the spatial distortion of the laser radiation effected by the offsetting of the emission sources (2) from the row;
- the prism angles of the individual prism elements (9) relative to one another, of the thicknesses of the individual plate elements (11) are selected in accordance with the spatial distortion of the laser radiation effected by the offsetting of the emission sources (2) from the row and determined during analysis.

14. Method according to Claim 13, **characterized in that** the laser light source (1) is mounted on a cooling device before the analysis of the laser radiation.

## Revendications

1. Arrangement pour la correction d'un rayonnement laser sortant d'une source de lumière laser (1), comprenant une source de lumière laser (1) qui présente des sources d'émission (2) en forme de lignes, lesquelles sont disposées en au moins une rangée dans une première direction (X), les sources d'émission (2) disposées dans une rangée étant en plus disposées dans une direction (Y) perpendiculaire à la première direction (X) en étant au moins partiellement décalées par rapport à la rangée, et l'arrangement comprenant en plus des moyens de correction (8, 10) comprenant au moins un élément prismatique (9) qui corrigent le rayonnement laser sortant de la source de lumière laser (1) de telle sorte que la distorsion dans l'espace du rayonnement laser provoquée par le décalage des sources d'émission (2) par rapport à la rangée soit compensée, **caractérisé en ce que** les moyens de correction (8) englobent une pluralité d'éléments prismatiques individuels qui sont assemblés de manière à former un réseau de prismes, les éléments prismatiques (9) étant disposés dans le rayonnement laser sortant de la source de lumière laser (1) de telle sorte que les rayons laser (3, 3') sortant d'au moins deux sources d'émission (2) décalées l'une par rapport à l'autre viennent heurter des éléments prismatiques (9) différents et sont déviés au niveau de l'une de leur surfaces de prisme sous un angle différent de manière à corriger la distorsion provoquée par le décalage de ces sources d'émission.

2. Arrangement pour la correction d'un rayonnement laser sortant d'une source de lumière laser (1), comprenant une source de lumière laser (1) qui présente des sources d'émission (2) en forme de lignes, lesquelles sont disposées en au moins une rangée dans une première direction (X), les sources d'émission (2) disposées dans une rangée étant en plus disposées dans une direction (Y) perpendiculaire à la première direction (X) en étant au moins partiellement décalées par rapport à la rangée, et l'arrangement comprenant en plus des moyens de correction (8, 10) qui corrigent le rayonnement laser sortant de la source de lumière laser (1) de telle sorte que la distorsion dans l'espace du rayonnement laser provoquée par le décalage des sources d'émission (2) par rapport à la rangée soit compensée, **caractérisé en ce que** les moyens de correction (10) sont réalisés sous la forme d'un réseau de plaquettes et le réseau de plaquette englobe une pluralité d'éléments à plaquettes (11) qui se composent de plaquettes à faces planes et parallèles transparents pour le rayonnement laser employé, au moins deux des éléments à plaquettes (11) présentant des épaisseurs différentes et les moyens de correction (10) étant disposés dans le rayonnement laser sortant de la source de lumière laser (1) de telle sorte que les rayons laser (3, 3') sortant d'au moins deux sources d'émission (2) décalées l'une par rapport à l'autre subissent un décalage de rayons d'intensités différentes par deux éléments à plaquettes (11) différents de manière à corriger la distorsion provoquée par le décalage de ces sources d'émission (2).

3. Arrangement selon la revendication 2, **caractérisé en ce que** les moyens de correction (10) sont disposés sous un angle (α) pouvant être prédéfini par rapport au sens de propagation médian du rayonnement laser qui les traverse.

4. Arrangement selon la revendication 3, **caractérisé en ce que** la normale à la surface d'entrée des moyens de correction (10) est disposée sous un angle (α) par rapport au sens de propagation médian (Z) du rayonnement laser qui traverse les moyens de correction (10).

5. Arrangement selon l'une des revendications 2 à 4, **caractérisé en ce que** les moyens de correction (10) sont réalisés sous la forme d'un bloc monolithique monobloc.

6. Arrangement selon l'une des revendications 1 à 5, **caractérisé en ce qu'**entre les moyens de correction (8, 10) et la source de lumière laser est disposée une lentille cylindrique (4) dont l'axe de cylindre s'étend dans une première direction (X).

7. Arrangement selon la revendication 6, **caractérisé en ce que** la lentille cylindrique (4) réalise une collimation du rayonnement laser sortant de la source de lumière laser (1) dans une direction (Y) perpendiculaire à la première direction (X).

8. Arrangement selon la revendication 6, **caractérisé en ce que** la lentille cylindrique (4) réalise une concentration du rayonnement laser sortant de la source de lumière laser (1) dans une direction (Y) perpendiculaire à la première direction (X).

9. Arrangement selon la revendication 8, **caractérisé en ce que** sur le côté opposé à la lentille cylindrique (4) du moyen de correction (10) réalisé sous la forme d'un réseau de plaquettes est disposé une lentille concave (12), laquelle casse le rayonnement laser concentré du point de vue de la direction (Y) perpendiculaire à la première direction (X) de telle sorte que celui-ci sort de la lentille concave (12) sous la forme d'un rayonnement laser pour l'essentiel parallèle par rapport à la direction (Y) perpendiculaire à la première direction (X).

10. Arrangement selon l'une des revendications 1 à 4 ou 6 à 9, **caractérisé en ce que** les éléments prismatiques (9) ou les éléments à plaquettes (11) sont collés les uns aux autres.

11. Arrangement selon l'une des revendications 1 à 10, **caractérisé en ce qu'**une ou plusieurs sources d'émission (2) sont associées à chacun des éléments prismatiques (9) ou à chacun des éléments à plaquettes (11).

12. Arrangement selon l'une des revendications 1 à 11, **caractérisé en ce que** la source de lumière laser (1) est réalisée sous la forme de barres de diodes laser.

13. Procédé pour fabriquer un arrangement selon l'une des revendications 1 à 12, **caractérisé par** les étapes suivantes :
- le rayonnement laser sortant de la source de lumière laser (1), après avoir traversé une lentille cylindrique (4) dont l'axe de cylindre est dirigé parallèlement à la première direction (X) dans laquelle s'étend également la rangée de sources d'émission (2), est analysé du point de vue de la distorsion dans l'espace du rayonnement laser provoquée par le décalage des sources d'émission (2) par rapport à la rangée ;
- les angles de prisme de chacun des éléments prismatiques (9) les uns par rapport aux autres ou les épaisseurs de chacun des éléments à plaquettes (11) sont choisis conformément à la distorsion dans l'espace du rayonnement laser déterminée dans le cadre de l'analyse et provoquée par le décalage des sources d'émission (2) par rapport à la rangée.

14. Procédé selon la revendication 13, **caractérisé en ce que** la source de lumière laser (1) est montée sur un dispositif de refroidissement avant l'analyse du rayonnement laser.
